# EUROPÄISCHE PATENTSCHRIFT

(11) **EP 2 716 437 B1**
(45) Veröffentlichungstag und Bekanntmachung des Hinweises auf die Patenterteilung: **29.04.2020**
(21) Anmeldenummer: 12187229.5
(22) Anmeldetag: 04.10.2012
(51) Int. Cl.: B29C 70/88

(54) **Verwendung eines Verbundbauteilsmit mit elektrischen Leitungen**
Use of a compound material with electric conductors
Utilisation d'un composant composite avec des conducteurs électriques

(43) Veröffentlichungstag der Anmeldung: 09.04.2014
(73) Patentinhaber: Magna Steyr Fahrzeugtechnik AG & Co KG, 8041 Graz (AT)
(72) Erfinder: Hofer, Bernhard, 8053 Graz (AT)
(74) Vertreter: Zangger, Bernd

(56) Entgegenhaltungen:
- EP-A1- 2 153 964
- WO-A2-2010/004262
- DE-A1- 4 221 454
- US-B2- 8 073 298

## Beschreibung

Die Erfindung betrifft eine Verwendung eines Verbundbauteils aus Kunststoff- Faser- Verbundwerkstoff mit mindestens zwei Lagen aus faserverstärktem Material, wobei zwischen die mindestens zwei Lagen aus faserverstärktem Material mindestens eine elektrische Leitung eingebracht ist.

### Stand der Technik

Ein Verbundwerkstoff ist eine Kombination von mindestens zwei oder mehreren verschiedenen Wirkstoffen, welche eindeutig unterschiedliche physikalische oder chemische Eigenschaften besitzen. Der daraus entstehende Verbundwerkstoff vereinigt die physikalischen und/oder chemischen Eigenschaften seiner Bestandteile. Gleichzeitig werden die positiven Eigenschaften für die jeweilige Anwendung hervorgehoben und die am wenigsten erwünschten unterdrückt. Die Komponenten werden dabei so ausgewählt und miteinander verbunden, dass jeder Stoff in seinen speziellen und für den vorliegenden Fall benötigten Eigenschaften beansprucht wird.

Auch in der Automobilindustrie wird zunehmend auch Kohlenstoff-Verbundwerkstoff für Leichtbaukomponenten eingesetzt. Durch das geringe Gewicht des Verbundmaterials wird dadurch die Gewichtszunahme im Automobilbau kompensiert. Vor allem für den Einsatz in sicherheitsrelevanten Bereichen zum Beispiel als verstärkter Aufprallträger werden Kohlenstoffverbund-Materialien eingesetzt. EP2153964 A1 offenbart eine Verwendung eines Verbundbauteils gemäß dem Oberbegriff des Anspruchs 1.

So ist aus der EP 1483137B1 ein Aufprallträger bekannt, der mit einem Metall-Schnurband verstärkt ist, wobei die Metallschnüre oder Drähte in einer oder mehreren Ebenen angeordnet sind. Diese Metallschnüre sind dabei zwischen Folien aus Polymermaterial laminiert. Für die Herstellung des Aufprallschutzes ist eine regelmäßige Ausrichtung der Metallschnüre sinnvoll, aber das Verbundmaterial Metall-Kunststoff ist für die Aufnahme von Kräften nicht optimal ausgelegt.

Aus der GB2041824 ist ein Verbundmaterial aus Kohlestofffaser- verstärktem Kunststoff in Kombination mit Metalldrahtgewebe bekannt. Dabei ist das Verbundmaterial alternierend aus dem verstärkten Kunststoff und dem Metallgelege aufgebaut.

Ein solcher Aufbau ist für den Einsatz für homogene Bauteile mit gleichmäßigem Verhalten gegenüber Krafteinträgen sinnvoll und stellt mit der Metalleinlage auch ein elektrisch leitfähiges Material dar.

Die vorliegende Erfindung löst die Aufgabe, ein Bauteil aus einem Verbundwerkstoff herzustellen, das außerhalb der Optimierungen der mechanischen Eigenschaften des Bauteils, ein elektrische Funktionalität aufweist.

Diese Aufgabe wird gelöst mit den Merkmalen des Anspruchs 1.

Gemäß der Offenbarung ist dabei ein elektrischer Anschluss vorgesehen, der entweder aus einem Bauteil besteht, der aus dem Verbundmaterial ragt oder durch herausragende Leitungen realisiert ist.

Gemäß der Offenbarung ist die elektrische Leitung Teil einer Lage von Metalldrähten oder Metallseilen.

Es ist dabei von Vorteil Metallseile, d.h. mehr als einen einzelnen Draht zu verwenden und diese mindestens zwei Drähte zu einem Metallseil zu verdrillen oder zu verseilen und/oder zu flechten.

Gerade durch die Verbindung des Verbundmaterials mit den Metallseilen wird die gewünschte Elastizität des Bauteils erreicht, die zum Beispiel für sicherheitsrelevante Bauteile im Aufprallschutz verwendet werden. Die Verseilung des Metalldrahtes zu Metallseilen führt zu einer erhöhten Elastizität, die eine ideale Ergänzung zu dem beispielsweise spröden Material eines Kohlenstoffverbund-Kunststoffs ist.

Vorteilhafterweise wird die Elastizität des Materials durch die Verwendung von Stahl für die Metallseile erhöht.

Es ist weiterhin vorgesehen, dass die Metallseile zu einem bidirektionalen Metallgelege verbunden werden, beispielsweise verwoben werden. Dadurch wird die Elastizität nicht nur in einer Richtung auf erhöhte und das Bauteil kann insgesamt optimiert werden. Für den Aufbau des Verbundbauteils ist es von Vorteil, dass sich die Metallseile zwischen oder auch auf den faserverstärkten Lagen des Verbundbauteils befinden. Dadurch kann die Eigenschaft des Verbundmaterials optimiert werden, da eine hohe Flexibilität für die Positionierung der Metallseile vorhanden ist.

Weiterhin ist es von Vorteil, dass bei der Verwendung von Stahlseilen als Metallteile und Lagen aus kohlestofffaserverstärktem Material eine Lage aus isolierendem Material zwischen den Metallteilen und den Kohlenstofffasern vorhanden ist, um die Korrosion zu minimieren.

Dabei kann vorteilhafterweise das isolierende Material eine Lage aus Kunststoff der Kunststoffverbundmatrix sein. Alternativ dazu ist es von Vorteil glasfaserverstärkten Kunststoff bzw. eine Glasfaser zu verwenden, der sowohl als isolierende Schicht verwendet wird, aber auch die Plastizität des Verbundes erhöht und dem spröden Verhalten der Kohlestoffschichten entgegenwirkt. Bei Verwendung von Glasfaser verstärktem Kunststoff können Bauteile und Strukturen hergestellt werden, deren Struktur bei einem Aufprall eher erhalten bleibt und bei denen die Metalleinlagen vor Korrosion geschützt sind. Auch die Verwendung der Glasfaser allein als isolierender und formstabiler Abstandshalter ist möglich.

Vorteilhafterweise werden ganze Karosserien aus den Verbundbauteilen hergestellt und die elektrischen Leitungen zwischen den Bauteilen verbunden. Dadurch wird das nachträgliche Verlegen von Leitungen im Fahrgastraum und das Einbringen der unterschiedlichen Verlegemittel eingespart.

### Beschreibung der Offenbarung

Die Offenbarung wird in den Zeichnungen beispielhaft dargestellt und in der nachfolgenden Beschreibung erläutert.

Es zeigt:
Fig.1 ein beispielhaftes Bauteil
Figur 2 eine schematische Darstellung der Metallgelege
Figur 3 ein weiteres beispielhaftes dreidimensionales Bauteil
Figur 4 eine Bauteil mit Isolationsschichten.
Figur 5 zeigt den Zusammenbau für eine Karosserie

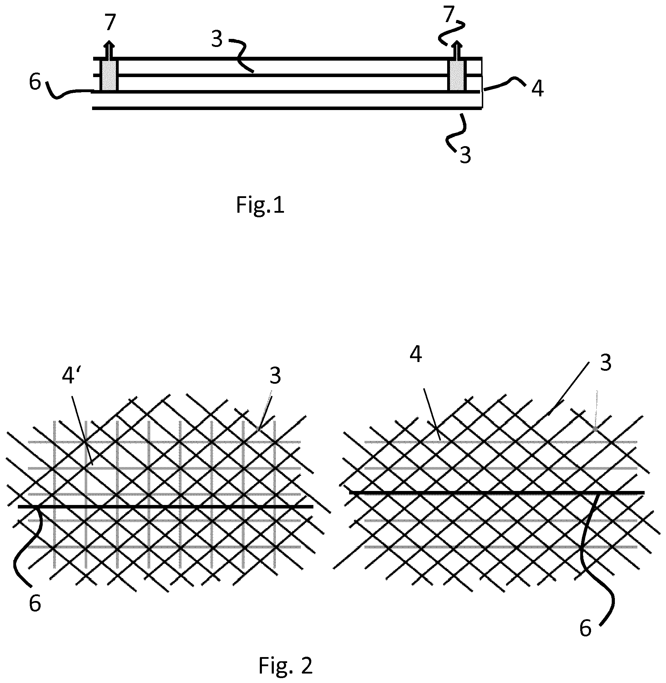

Figur 1 zeigt einen beispielhaften Aufbau von Schichten nach dem offenbarungsgemäßen Gegenstand. Die Schichten werden auf einer planen Fläche für die weitere Verarbeitung vorbereitet. Im Beispiel der Figur 1 sind unterschiedliche vorimprägnierte Faserschichten aus faserverstärktem Material, beispielsweise aus Kohlenstofffaser 3 vorgesehen. Diese vorimprägniert Faserschichten werden als Prepreg bezeichnet und bestehen aus Fasern und einer ungehärteten duroplastischen Kunststoffmatrix.

Auf oder zwischen die Kohlenstofffaserschichten 3 werden Schichten 4 aus Metallseilen angeordnet. Diese Schicht enthält mindestens eine elektrische Leitung 6, die durchgängig zwischen zwei Anschlüssen 7 verlegt ist. Zusätzlich zur elektrischen Leitung können Metallseile als Metallgelege eingebracht sein. Der Aufbau der einzelnen Schichten erfolgt nach den Anforderungen an den Verbundwerkstoff und kann automatisiert ablaufen. Die elektrischen Anschlüsse sind in der Zeichnung schematisch dargestellt. Es kann sich dabei um Steckverbindungen unterschiedlicher Art oder auch um einfache Verlängerungen der elektrischen Leitungen handeln, die nach außen geführt werden. Die elektrischen Leitungen können extra verlegte Kabel sein oder ein Teil des Metallgeleges wird als elektrische Leitung zusätzlich zu der Verstärkungsaufgabe verwendet. Dabei werden einzelne Metalldrähte des Metallgeleges kontaktiert oder auch ganze Bündel von Metalldrähten oder Metallseilen. Die elektrische Isolierung der Metalldrähte gegeneinander erfolgt über die Matrix. Gegebenenfalls müssen die zu kontaktierenden Teile des Metallgeleges vor dem Einbringen des Kunststoffs mit einer Isolation versehen werden.

Das geschichtete Bauteil wird in ein Werkzeug eingebracht, das ein unteres Werkzeugteil 2 und ein oberes Werkzeugteil aufweist. In diesem Werkzeug wird das vorgelegte Bauteil gegebenenfalls verformt und entweder in einem Autoklaven ausgehärtet oder mithilfe von RTM- Verfahren mit einer Formmasse verpresst und unter Wärme und Druck ausgehärtet.

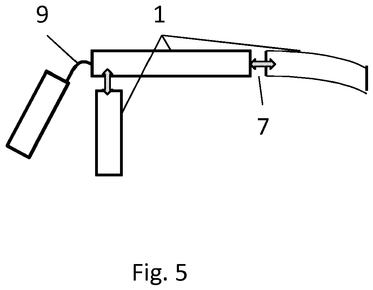

Bauteile solcher Art können für die Herstellung ganzer Karosserien verwendet werden wie in Figur 5 dargestellt, wobei keine zusätzliche Verlegung von elektrischen Leitungen in der Fahrgastzelle notwendig ist. Die elektrischen Anschlüsse 7 werden entweder direkt oder über Kupplungen 9 mit weiteren Verbundmaterialbauteilen 1 verbunden. Die Kupplungen sind dabei entweder starre oder flexible Bauteile. Dadurch erhält man eine Baustruktur für elektrische Leitungen, die alle Verlegemittel im Fahrzeug einspart und auch die Isolation der elektrischen Leitungen übernimmt.

Figur 2 zeigt eine beispielhafte Anordnung von Prepregs. Das kohlefaserverstärkte Material 3 ist in diesem Fall ein gleichmäßiges Gewebe aus Kohlenstofffasern. Allerdings ist für die Ausführung der Offenbarung auch ein Einsatz von kohlenstofffaserverstärktem Material denkbar, in dem die Kohlenstofffasern eine bevorzugte Richtung haben. Auf der rechten Seite der Figur 2 ist das Metallgelege 4 horizontal ausgerichtet. Es handelt sich dabei um Metallseile, die aus mindestens zwei Drähten, die umeinander verdrillt sind, hergestellt werden. Diese Metallseile, die aus Drähten zusammen gebündelt werden, sind in diesem Beispiel beabstandet voneinander parallel verlegt. Eine beispielhafte elektrische Leitung 6 ist mit den Metallseilen direkt verbunden, sie kann aber auch getrennt von den Metallseilen eingebracht werden. Auf der linken Seite der Abbildung 2 sind die Metallseile senkrecht zu den horizontalen Anordnungen weiterer Metallseile angeordnet und bilden ein Metallseilgitter als Metallgelege, das als Ganzes in das Bauteil eingelegt wird. Hier ist die elektrische Leitung 6 getrennt vom Metallgelege eingebracht. Da die elektrische Leitung nicht notwendigerweise gleichzeitig die Aufgabe erfüllt, die Elastizität des Verbundwerkstoffs zu verbessern, kann sie so verlegt werden, dass sie die elektrischen Anschlüsse des Bauteils optimal verbindet.

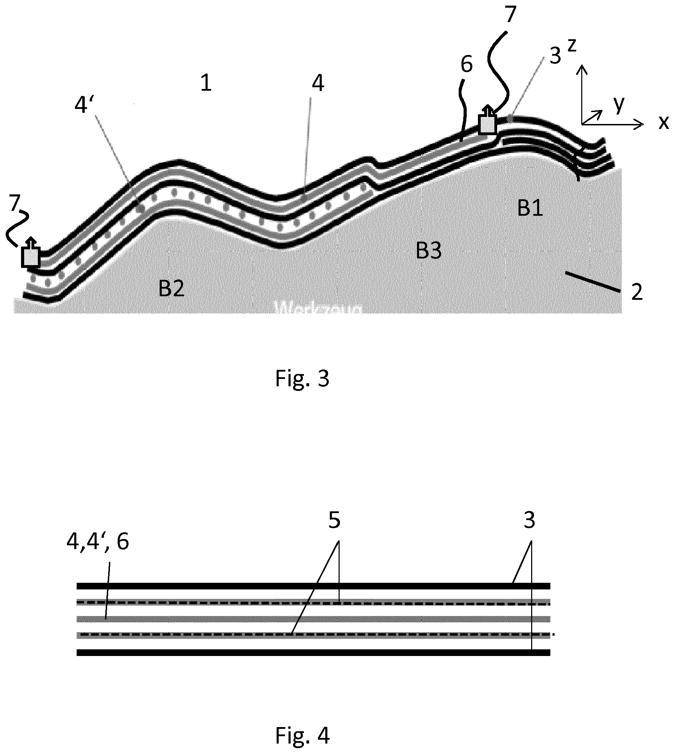

Die in diesem Beispiel gezeigte Anordnung der Metallseile ist nur eine mögliche Ausführungsform. Die Metallseile können ein Metallgelege bilden, das an einem Punkt durch dichteres Legen der Metallseile verstärkt, an anderen Stellen durch ein lockeres Legen schwächer ausgelegt ist. Auch eine Parallelität der Metallseile ist nicht notwendig. Figur 3 zeigt ein weiteres Bauteil, das auf der Oberseite eines unteren Werkzeugteils 2 aufgebaut wird. Das Bauteil 1 besteht wiederum aus unterschiedlichen alternierend in Schichten aus kohlefaserverstärkten Lagen 3 oder unidirektionalen Metallgelegen 4 bzw. bidirektional ausgerichteten Metallgelegen 4'. Durch die unterschiedliche Orientierung der Metallseile in den Metallgelegen 4 und 4' wird das erzeugte Bauteil in seiner Elastizität optimiert.

Wie aus dem Beispiel zu erkennen ist, weist das Bauteil unterschiedliche Bereiche B1, B2, B3 auf. Diese Bereiche sind in der x, y Ebene definiert, nicht in der Schichtebene z des Bauteils. Die Bereiche können unterschiedlich groß sein und unterschiedliche Formen in der x, y-Ebene aufweisen. Im Bereich B1 des Bauteils sind nur Lagen von kohlenstoffffaserverstärktem Material vorhanden. Im Bereich B2 weist das Bauteil zwei Lagen von Metallseilen auf, im Bereich B3 eine Lage mit einem Metallseilgelege. Auf eine erste Schicht aus kohlenstoffffaserverstärktem Kunststoff wird eine zweite Schicht in diesem Fall alternativ eine Schicht aus Kohlenfaser verstärktem Kunststoff oder einem Metallgelege aufgelegt. Je nach Beanspruchung der einzelnen Bereiche B1, B2, B3 werden Metallgelege oder weitere kohlenstoffffaserverstärkte Kunststofflagen aufeinander geschichtet.

Für die Herstellung des Metallgeleges werden Metalldrähte, vorzugsweise Stahldrähte verwendet. Bei der Verwendung von Stahldrähten ist zu berücksichtigen, dass Korrosion an diesen Stahldrähten auftritt, wenn der Stahl mit den Kohlenstofffasern in Verbindung kommt. Um dieses Problem zu minimieren wird, wie in Figur 4 gezeigt, eine Isolationsschicht 5 zwischen Metallgelege 4,4', in diesem Fall dem Stahlgelege und den Kohlenstofffaserschichten 3 eingeführt.

Die Isolationsschicht 5 ist in einem Ausführungsbeispiel eine Schicht aus Harz oder dem Kunststoff der Kunststoffmatrix, die im Produktionsverfahren eingebracht wird und einen Abstand zwischen dem Stahlgelege und den Kohlenstofffasern herstellt und ausfüllt. In einer alternativen Ausführungsform wird die Isolationsschicht 5 aus glasfaserverstärktem Kunststoff hergestellt. Der Vorteil bei der Verwendung von glasfaserverstärktem Kunststoff ist, dass das dadurch die Plastizität des Kunststoffverbundes erhöht wird und dem spröden Verhalten der KohlenstoffFaserschichten entgegengewirkt wird. In einer Ausführungsform mit isolierender Glasfaser-Kunststoffschicht kann das Bauteil in einem Aufprall eher erhalten werden und die Stahleinlagen sind gleichzeitig vor Korrosion geschützt.

Als weitere isolierende Schichten sind auch Materialien wie Zellulose, Basalt und Ähnliches möglich, die eine reine Isolationswirkung aber keinen weiteren Einfluss auf die Elastizität des Materials haben.

Um das Problem mit der Korrosion zu vermeiden werden Metallseile aus Aluminium verwendet, die die Stahlseile ersetzen können.

In einer alternativen Ausführungsform werden die elektrischen Leitungen aus geeigneten Metallen wie Kupfer und/oder Aluminium hergestellt und in den Verbundwerkstoff eingelegt. Unabhängig davon, ob im Verbundwerkstoff noch weitere Metallbauteile eingelegt sind, werden die elektrischen Leitungen mit oder ohne eigene Isolationsschicht verlegt.

Zur Herstellung der Verbundmaterialien werden die bekannten Kunststoffmatrizen und Harze verwendet.

## Patentansprüche

1. Verwendung eines Verbundbauteils (1) aus Kunststoff- Faser- Verbundwerkstoff mit mindestens zwei Lagen aus faserverstärktem Material, wobei zwischen die mindestens zwei Lagen von faserverstärktem Material (3) mindestens eine elektrische Leitung (6) eingebracht ist, wobei die elektrische Leitung (6) Teil einer Lage von Metallseilen ist, die mit elektrischen Anschlüssen (7) verbindbar ist, wobei die Metallseile ein bidirektionales Metallgelege (4') bilden, so dass die Elastizität des Verbundbauteils in mindestens zwei Richtungen erhöht wird, **dadurch gekennzeichnet, dass** ein Teil des Metallgeleges (4') als elektrische Leitung (6) zusätzlich zu der Verstärkungsaufgabe verwendet wird, wobei die elektrischen Anschlüsse (7) im Verbundbauteil (1) integriert sind, oder die elektrischen Anschlüsse als elektrische Leitungen aus dem Verbundbauteil ragen.

2. Verwendung eines Verbundbauteils nach Anspruch 1, **dadurch gekennzeichnet, dass** die Metallseile (4,4') aus zueinander verdrillten Einzeldrähten bestehen.

3. Verwendung eines Verbundbauteils nach Anspruch 1, **dadurch gekennzeichnet, dass** die elektrischen Leitungen (6) aus verdrillten Drähten oder Litzen bestehen.

4. Verwendung eines Verbundbauteils nach Anspruch 1, **dadurch gekennzeichnet, dass** die Metallseile aus Stahl bestehen.

5. Verwendung eines Verbundbauteils nach Anspruch 1 **dadurch gekennzeichnet, dass** die faserverstärkte Lagen (3) mindestens einen Lage aus kohlenstofffaserverstärktem Material aufweisen.

6. Verwendung eines Verbundbauteils nach Anspruch 1, **dadurch gekennzeichnet, dass** die Lage der Metallseile (4) sich zwischen oder auf der kohlefaserverstärkten Lage (3) befindet.

7. Verwendung eines Verbundbauteils nach Anspruch 1, **dadurch gekennzeichnet, dass** die Metallseile (4) durch mindestens eine Lage aus isolierendem Material (5) von den Kohlestofffasern (3) getrennt ist.

8. Verwendung eines Verbundbauteils nach Anspruch 1, **dadurch gekennzeichnet, dass** die mindestens eine elektrische Leitung (6) mit eigener Isolation versehen ist.

9. Verwendung von Verbundbauteilen nach einem der vorherigen Ansprüche, **dadurch gekennzeichnet, dass** die Verbundbauteile (1) Teile einer Fahrzeugkarosserie darstellen, und dass die mindestens eine elektrische Leitung (6) über elektrische Anschlüssen (7) mindestens zwei Verbundbauteile direkt oder indirekt verbindet.

10. Verwendung von Verbundbauteilen nach Anspruch 9, **dadurch gekennzeichnet, dass** die elektrische Verbindung über starre und/oder flexible Kupplungen (9) erfolgt.

## Claims

1. Use of a composite component (1) composed of a plastics-fibre composite material, having at least two plies of fibre-reinforced material, wherein, between the at least two plies of fibre-reinforced material (3), there is inlaid at least one electrical line (6), wherein the electrical line (6) is part of a ply of metal cords that can be connected to electrical terminals (7), wherein the metal cords form a bidirectional metal laid fabric (4'), such that the elasticity of the composite component is increased in at least two directions, **characterized in that** a part of the metal laid fabric (4') is used not only for its reinforcement task but also as an electrical line (6), wherein the electrical terminals (7) are integrated in the composite component (1), or the electrical terminals project in the form of electrical lines out of the composite component.

2. Use of a composite component according to Claim 1, **characterized in that** the metal cords (4, 4') are composed of individual wires which are twisted with one another.

3. Use of a composite component according to Claim 1, **characterized in that** the electrical lines (6) are composed of twisted wires or strands.

4. Use of a composite component according to Claim 1, **characterized in that** the metal cords are composed of steel.

5. Use of a composite component according to Claim 1, **characterized in that** the fibre-reinforced plies (3) have at least one ply of carbon-fibre-reinforced material.

6. Use of a composite component according to Claim 1, **characterized in that** the ply of the metal cords (4) is situated between or on top of the carbon-fibre-reinforced ply (3).

7. Use of a composite component according to Claim 1, **characterized in that** the metal cords (4) are separated from the carbon fibres (3) by at least one ply of insulating material (5).

8. Use of a composite component according to Claim 1, **characterized in that** the at least one electrical line (6) is provided with dedicated insulation.

9. Use of composite components according to one of the preceding claims, **characterized in that** the composite components (1) constitute parts of a vehicle body, and **in that** the at least one electrical line (6) directly or indirectly connects at least two composite components via electrical terminals (7).

10. Use of composite components according to Claim 9, **characterized in that** the electrical connection is realized via rigid and/or flexible couplings (9).

## Revendications

1. Utilisation d'un composant composite (1) en un matériau composite constitué de matière synthétique et de fibres et présentant au moins deux couches de matériau renforcé de fibres, au moins un conducteur électrique (6) étant placé entre les deux ou plusieurs couches de matériau (3) renforcé de fibres, le conducteur électrique (6) faisant partie d'une couche de câbles métalliques qui peut être reliée à des bornes (7) de raccordement électrique, les câbles métalliques formant une couche métallique bidirectionnelle (4') de telle sorte que l'élasticité du composant composite soit augmentée dans au moins deux directions, **caractérisée en ce que**
une partie de la couche métallique bidirectionnelle (4') est utilisée comme conducteur électrique (6) en plus de remplir sa fonction de renfort, les bornes (7) de raccordement électrique étant intégrées dans le composant composite (1) ou les bornes de raccordement électrique débordant hors du composant composite sous la forme de conducteurs électriques.

2. Utilisation d'un composant composite selon la revendication 1, **caractérisée en ce que** les câbles métalliques (4, 4') sont constitués de fils individuels torsadés les uns avec les autres.

3. Utilisation d'un composant composite selon la revendication 1, **caractérisée en ce que** les conducteurs électriques (6) sont constitués de fils torsadés ou de tresses.

4. Utilisation d'un composant composite selon la revendication 1, **caractérisée en ce que** les câbles métalliques sont constitués d'acier.

5. Utilisation d'un composant composite selon la revendication 1, **caractérisée en ce que** les couches (3) renforcées de fibres présentent au moins une couche de matériau renforcé par des fibres de carbone.

6. Utilisation d'un composant composite selon la revendication 1, **caractérisée en ce que** la couche de câbles métalliques (4) est située entre ou sur les couches (3) renforcées de fibres de carbone.

7. Utilisation d'un composant composite selon la revendication 1, **caractérisée en ce que** le câble métallique (4) est séparé des fibres de carbone (3) par au moins une couche de matériau isolant (5).

8. Utilisation d'un composant composite selon la revendication 1, **caractérisée en ce que** le ou les conducteurs électriques (6) sont dotés d'une isolation propre.

9. Utilisation de composants composites selon l'une des revendications précédentes, **caractérisée en ce que** les composants composites (1) font partie d'une carrosserie de véhicule et **en ce que** le ou les conducteur électrique (6) relient directement ou indirectement au moins deux composants composites par l'intermédiaire de bornes (7) de raccordement électrique.

10. Utilisation de composants composites selon la revendication 9, **caractérisée en ce que** la liaison électrique s'effectue par des raccords (9) rigides et/ou des raccords (9) flexibles.
